# EUROPEAN PATENT APPLICATION

(11) **EP 3 936 813 A1**
(43) Date of publication of application: **12.01.2022**
(21) Application number: 20895921.3
(22) Date of filing: 06.10.2020
(51) Int. Cl.: F41B 15/04, H03K 3/53

(54) **SHOCK CURRENT GENERATOR FOR ELECTROSHOCK WEAPONS**

(30) Priority: 04.12.2019 RU 2019139513
(71) Applicant: Gabliya, Yuriy Aleksandrovich, Moscow, 121069 (RU)
(72) Inventor: LADYAGIN, Yuriy Olegovich, Moscow, 123056 (RU)
(74) Representative: Plasseraud IP
(86) International application number: PCT/RU2020/000521
(87) International publication number: WO 2021/112717

(57) **Abstract**

The invention relates to technology for producing high-voltage shock current pulses for non-lethal contact electroshock weapons and long-range electroshock weapons, and also to general technology for producing high-voltage high-current pulses. Field of use: Contact and long-range electroshock weapons for law-enforcement services and citizens, experimental technology. The technical result is the production of high-current pulses including long pulses, with a generator having minimal dimensions and cost and a high level of reproducibility. A high-voltage pulse generator comprises a power source, a converter, a voltage multiplier, a capacitor, which is connected in a discharging circuit of the multiplier via a high-voltage diode assembly and an air or gas spark gap and can be charged from a rectifier that is supplied from the converter, wherein a protective regulating spark gap is arranged between an output electrode and the circuit elements.

## Description

### Field of the invention

The invention relates to technology for producing high-voltage shock current pulses of non-lethal contact electroshock weapons (ESHO) and long-range electroshock weapons (DESHO) for law enforcement agencies, and in a lesser extent to general technology of producing high-voltage, high-current pulses.

### State of the art

An analogue of the proposed generator is widely known voltage multipliers (multipliers), for example, the Cockcroft-Walton (Greinacher) cascade generator [1; 2]. The principle of operation of such a generator is that the constant voltage of a lowvoltage source of electricity (accumulator or battery) is converted by a converter (inverter) into an alternating or pulsed voltage of the generator supply, then it is rectified on diodes and charges the capacitors of individual cascades, and then the resulting constant voltages of the charged capacitors are summed up.

ESHO and DESHO with a high-voltage output voltage multiplier (multiplier output) are widely used all over the world in budgetary but physiologically ineffective [3] products of low-budget arms companies in the Southeast (China, Taiwan, Singapore) supplied to the markets of the poorest countries of the world and especially to Russia where dozens of counterfeit ESHO versions come across the border. The reason for the use of high-voltage multipliers in such ESHO is the high efficiency factor of multipliers, low cost, spectacular visual appearance (discharge brightness) and crackle of the spark discharge (spark noise), which has good psychological effect in reducing the aggression of attackers toward the ESHO user, and also the constant level of reproducibility of high-voltage multipliers even in low-tech conditions of manufacturing compared to the ESHO and DESHO with a high-voltage transformer at the output (transformer output) used in high quality, expensive ESHO. The high cost of ESHO and DESHO with the transformer output is due to the fact that the high-voltage small-sized output transformer, which is the critical unit of the ESHO and DESHO, is the most expensive unit being reproducible without a significant percentage of rejects only at high tech enterprises and only with the technology of winding and casting of transformers with electrical insulating compounds that has been worked out for years of production. Therefore, companies that do not own high technologies and production culture, produce ESHO and DESHO with high-voltage multipliers at the output. In Russia, for example, such a low-tech company that produced ESHO "Yana" in various versions with the multiplying output for many years is JSC "Research Institute of Steel", which is the leading enterprise in the field of materials and structures for protecting weapons and military equipment of the ground forces, the Ministry of Internal Affairs and other defense and law enforcement agencies of the country.

The disadvantage of all types of multipliers for use in ESHO and DESHO is the impossibility of obtaining an effective physiological effect on a biological target (target, bio-target, offender) at different distances between the output electrodes of the ESHO with the multiplying output and the bio-target, as a result of which the use of multipliers in ESHO and DESHO is ineffective. If in the widespread ESHO and DESHO with the high-voltage transformer output, the discharge of the pumping capacitor of the primary winding of the high-voltage transformer occurs only when it reaches the maximum charge voltage (i.e., at the maximum energy in the capacitor), then when using a cascade multiplier at the output of the ESHO or DESHO, capacitor cascades are discharged to the bio-target at maximum charge energy only at the maximum for the generator distance of the electrical spark breakdown between the output (striking) electrodes of the ESHO or DESHO (combat discharge gap), that is, at the maximum distance between each of the output electrodes and the bio-target equal to 1/2 of the maximum distance of the spark electrical breakdown between two output (striking) electrodes. For example, to pierce the thick clothes of an offender, a higher voltage is needed, and, accordingly, the cascades of capacitors have time to accumulate significant energy before being discharged via an air gap determined by the thickness of the clothes onto the body of the bio-target. In the case, where the thickness of the clothes is insignificant, the cascades of capacitors will pierce a small air distance without accumulating the full energy, and therefore, the level of the effect will be small. In full ohmic contact with human skin, the effect will be minimal and equal to the output characteristics of the inverter transformer at a given load. That is, with a decrease in the distance between the output electrodes of the ESHO or DESHO and the body of the bio-target, the discharge frequency will increase, and at the minimum distance to the body (full contact) it will become equal to the frequency (usually 10-60 kHz) of the inverter (power converter of the cascade generator) at the output voltage of the inverter transformer (usually 1-5 kV). Such a pulsed voltage with an inverter output current of about 5-10 mA and a frequency of tens of kilohertz is absolutely not effective when acting on the bio-target in order to suppress his or her aggression and immobilize it, due to inflicting only superficial burns similar to the action of a medical bipolar coagulator. With an increase in the distance between the output electrodes of the ESHO or DESHO and the target body, the current frequency drops due to the consumption of the inverter's energy during the time of charging the capacitors of the voltage multiplier cascades to a higher potential, and the level of the physiological effect on the bio-target gradually increases, reaching a maximum at the full possible breakdown distance in air of the multiplier limited by the distance between electrodes of the ESHO or DESHO protective spark gap. However, at the maximum possible breakdown distance, the intrinsic energy losses in the spark electrical breakdown in air also increase somewhat. Therefore, with a decrease in the distance between the output electrodes of the ESHO or DESHO (that is, in fact, reducing the thickness of the clothes of the offender), the effectiveness of the ESHO or DESHO is reduced to almost zero, since the high frequency of the current (tens of kilohertz) of the power supplies (inverters) of the cascade generators in the ESHO and DESHO is physiologically ineffective and causes only very minor superficial thermal burns. The ESHO and DESHO with multiplier output can have the optimal physiological effect only at a certain distance between the output electrodes and the target. In addition, the ESHO and DESHO with the multiplier output, even at the optimal distance between the output electrodes and the target, have low physiological effectiveness due to the short pulse duration [4] arising from small total capacity of the capacitors in the stages and the impossibility to increase pulse duration beyond 5-15 µs. due to the limited overall dimensions of the ESHO and DESHO, convenient for wearing by the user, since an increase in the total capacity is possible only with an increase in the capacity (i.e. dimensions) of each capacitor in the cascade. Until now, attempts to improve the physiological effectiveness of the ESHO and DESHO with multiplier output have not led to positive results [5], primarily because the voltage multiplier does not have a threshold unit providing uniform pulse parameters at any distance between the output electrodes and the load, which is a necessary condition for ensuring physiological effectiveness of the ESHO and DESHO. The threshold unit in the voltage multiplier in relation to its use in the ESHO and DESHO is an air gap itself (which is an air spark gap) between the output electrodes of the multiplier and the target. When the size of this air gap changes, the frequency and energy of the discharge pulses of the multiplier capacitor cascades on the load change and, accordingly, the physiological effectiveness of such pulses changes from extremely insignificant to acceptable, but never reaching the physiological effectiveness of the ESHO and DESHO with the transformer output due to the short pulse duration along with its significant amplitude. Until now, increasing the pulse duration in the ESHO and DESHO with the multiplier output to physiologically effective values (80-150 µs) [4] while keeping the dimensions of the ESHO and DESHO suitable for wearing, nowhere in the world has been possible due to the fact that the maximum specific energy capacity of capacitors is achieved at the minimum dielectric thickness, that is, at the minimum values of the charge voltage. However, in voltage multipliers of the ESHO and DESHO, only high-voltage capacitors are used, and when they are connected in series to achieve the capacity of the capacitors necessary to obtain the pulse duration with the necessary physiological effectiveness, the total volume and weight of the capacitors become unacceptable for use in the ESHO and DESHO wearable by the user.

A high-voltage pulse generator according to the patent of the Russian Federation No. 2698245 is selected as another analogue of the inventive generator, which analogue uses a different type of high-voltage source of electrical current damaging the target than in the inventive generator. The principle of operation of such a generator is based on the operation of the Erwin Marx generator [6], wherein a current capacitor having significant charging capacity compared to the capacity of the capacitors of the stages of the Marx generator, which is charged by a direct current source supplying the cascades of the Marx generator, is connected parallel to the output of the generator via a solid-state high-voltage diode assembly that prevents the pulse of the Marx generator from breaking the current capacitor and discharging on it. Such a generator can be used in the ESHO and DESHO, since its action does not depend on the distance between the output electrodes of the ESHO and DESHO and the body of the bio-target due to the fact that the Marx generator works only in a pulsed mode and the current capacitor charged from the direct current power source supplying the cascades of the Marx generator is always charged to the full charge voltage (that is, up to maximum energy) with discharging to the bio-target via the ionized channel formed with every pulse generated by the high-voltage Marx generator. Every high-voltage pulse of the Marx generator occurs only when the current capacitor is fully charged, since the ignition voltage of the trigger spark gap of the Marx generator is selected equal to the full charge voltage of the current capacitor. The advantage of such a generator as applied to the use in the ESHO and DESHO is that the use of the current capacitor of significant capacity at a low charge voltage makes it possible to produce long pulses on the load (bio-target) which are physiologically effective. At the same time, the use of the current capacitor makes it possible to use capacitors of the Marx generator cascades with insignificant capacity and dimensions, since the current capacitor supplies the main energy to the bio-target. This analogue has the following disadvantages that prevent its widespread use in the ESHO and DESHO. The use of protective dividing resistors in the generator reduces the efficiency factor of the generator, wherein, due to the necessary small size of the ESHO and DESHO, the use of charging chokes with low resistance and significant inductance increases the dimensions of the ESHO and DESHO to unacceptable values. The use of charging chokes with low resistance and low inductance can bring their dimensions closer to the dimensions of the protective dividing resistors, but in this case, due to parasitic current flow losses between the cascades, the maximum voltage of the high-voltage pulse sharply decreases and, as a result, the distance of breakdown voltage in air (i.e., in fact, the penetrable thickness of the bio-target clothes) in the ESHO and DESHO is also decreased. In this case, to compensate for the decrease in the breakdown distance in air, it is necessary to add stages to the Marx generator, with both a corresponding increase in the dimensions of the generator and further decrease in efficiency factor. In addition to the losses mentioned above, the efficiency factor of the Marx generator is also reduced by the losses in the discharge gaps of multiple spark gaps. Another drawback of the Marx generator based on air spark gaps and, accordingly, the analogue generator is the fundamental impossibility of obtaining a pulse repetition rate higher than several tens of Hertz, where only in the best experimental versions that are practically unreproducible in series it reaches about 100 Hz [7]. A higher frequency on Marx generators can be obtained only by using hydrogen spark gaps under pressure or by blowing off ionized gas in the inter-discharge intervals of the spark gaps or by placing the entire generator structure in a pressurized volume. All these solutions are unacceptable in the production of the ESHO and DESHO due to huge increase in size and weight, as well as cost. At the same time, the effect of increasing the physiological effectiveness of the ESHO and DESHO with an increase in the operating frequency above 100 Hz is known, and in particular the leading Russian manufacturers (for example, OOO "MART-GROUP"; ZAO "OBERON-ALJA", etc.) of the ESHO and DESHO use pulse repetition rate over 100 Hz (150-200 Hz) in their products. Also, the production of the primary unit of said analogue generator (that is, the Marx microgenerator) is fraught with significant technological difficulties. With insignificant charge voltages of the Marx generator cascades from the inverter (1-5 kV), for satisfying the electric strength conditions for the high frequency output microtransformers of the inverter, to produce a shock open-circuit voltage of the professional ESHO and DESHO for law enforcement agencies of 50-90 kV (and more), that is, in fact, a long distance of the ESHO and DESHO spark electrical breakdown in air and clothes with the Marx generator, it is necessary to use at least 6-10 stages with the corresponding individual manual setting of 6-10 air spark gaps. It is not possible to tune Marx microgenerators automatically or tune spark gaps using a measuring probe. The use of gas spark gaps with a set ignition voltage (2.5 ÷ 5.5 kV) in the Marx microgenerators, even from the world leading company EPCOS, reduces the breakdown distance possible by the number of stages by more than 50% due to the spread in the ignition voltage in each individual spark gap by 20% and the corresponding losses. At the same time, small-sized gas spark gaps made in Russia, in contrast to EPCOS spark gaps, have an insignificant resource (only hundreds of discharges versus hundreds of thousands or more in EPCOS spark gaps, with an assortment of only two barely acceptable ignition voltages (R-159, ignition voltage 1.0 kV, and R-160, ignition voltage 1.5 kV). If decreasing the number of stages is desired, it is necessary to use large charge voltage values of the Marx generator, that is, to use a voltage multiplier between the inverter and the generator (that is, an additional electronic unit), which again increases the dimensions and the cost and reduces the operational reliability of the generator. Air spark gaps of the Marx microgenerator unit in the analogue generator have an unstable ignition voltage at different air humidity and pressure, and therefore cannot ensure the constant maximum charge energy of the current capacitor and the maximum distance of electrical breakdown in air at high humidity and low atmospheric pressure, in this connection, it is necessary either to artificially reduce the distance between the output electrodes of the ESHO or DESHO or, if the constant breakdown distance between the output electrodes is desired, to increase the number of stages in the Marx generator, which again increases the dimensions and cost of the analogue generator and reduces the efficiency factor.

Patent search did not reveal a direct prototype of the inventive generator in the prior art.

### Disclosure of the invention

The invention is aimed at solving the task of developing a generator of high-voltage shock current pulses for electroshock weapons, which generator, in comparison with the first considered analogue, has an increased physiological effectiveness and constant physiological effect when the distance between the output electrodes and the bio-target changes, and in comparison with the second considered analogue, has higher efficiency factor and pulse repetition rate, reduced overall dimensions and industrial reproducibility in the conditions of Russian enterprises that do not have high production culture and high tech equipment. The proposed generator can also be used in various applied areas of technology where it is necessary to have a high-current electrical breakdown at large distances between the electrodes, in particular, research technology, technology for fuel ignition in gas turbine engines and liquid propellant rocket engines.

The essence of the invention lies in the fact that in the shock current generator for electroshock weapons, which generator comprises a voltage multiplier with output electrodes and stages charged by the voltage of a power source of 1 ... 10 kV, a current capacitor, which is charged via a solid-state rectifier with the input voltage of the power source of the cascades of the voltage multiplier stages, is connected parallel to the output electrodes of the voltage multiplier via at least one solid-state high-voltage diode assembly, which diode assembly is connected in reverse polarity to polarity of the output potential of the voltage multiplier, and an air or gas spark gap, wherein at least one, preferably protective regulating gas spark gap is arranged in the electrical circuit between at least one output electrode of the generator and the rest of the elements of the electrical circuit of the generator.

An additional feature is that a resistor is arranged in the electrical circuit between the power input terminal of the voltage multiplier and the output terminal of the power supply.

### Brief Description of the Drawings

FIG. 1. Shock current generator according to claim 1 of the present invention with a power source of 1-5 kV (principal electrical circuit).
FIG. 2. Shock current generator according to claim 1 of the present invention with a power source of 5-10 kV (principal electrical circuit).
FIG. 3. Experimental generator of FIG. 1 in operation.
FIG. 4. Experimental generator with the main elements magnified.

### Implementation of the invention

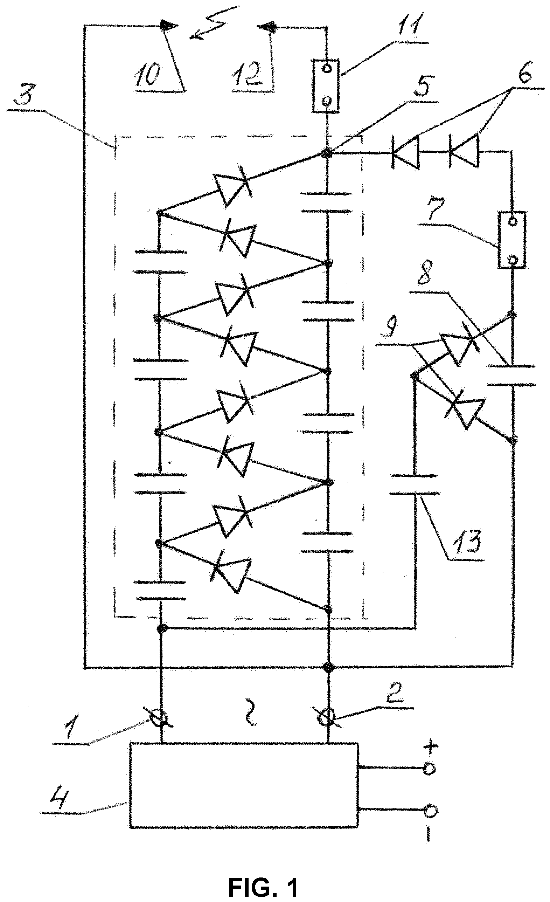

FIG. 1. A shock current generator designed for the use of a power source with an output voltage of 1-5 kV operates as follows: To outputs 1 and 2 designated for charging the stages of the cascade voltage multiplier 3 (highlighted by a dashed line in FIG. 1), an alternating voltage from a power source of 1-5 kV is supplied, which is received from inverter 4 being a DC/AC-converter (of constant low (3-12 V) voltage of the power supply, that is a battery or accumulator, into high alternating or pulsed voltage of 1 ... 5 kV). A solid-state high-voltage diode assembly 6 is connected to the point 5 in the circuit (end of the cascades) of the cascade of the multiplier stages in reverse polarity to the output potential of the multiplier and in series with the assembly, an air or gas current spark gap 7 and then one output of the current capacitor 8 charged via the rectifier 9 of the electrical current from the input alternating supply voltage of the multiplier, and the other end of the cascade (the beginning of the cascades) of the multiplier stages and the output electrode 10 are connected to the second output of the capacitor 8. To the point 5, one output of the protective regulating air or gas spark gap 11 is also connected, the second output of which is the output electrode 12.

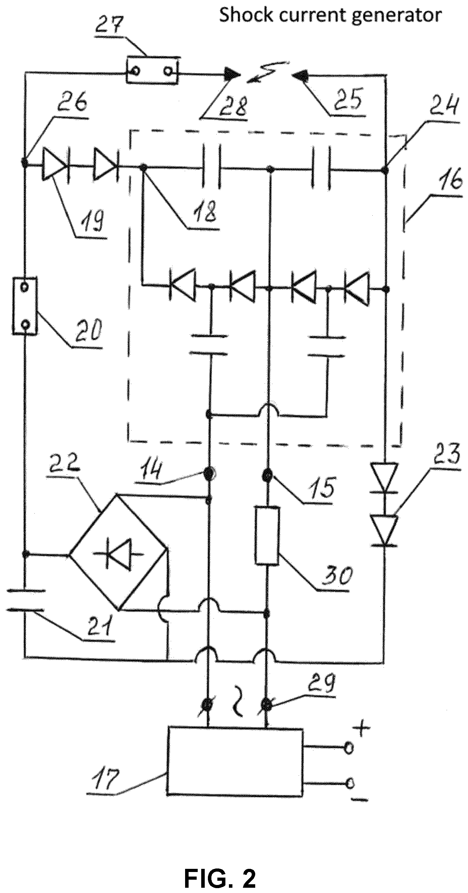

The generator operates as follows. When the inverter 4 is turned on, the alternating current of the generator supply generated by the inverter enters the circuit and charges the capacitors of the cascade of the multiplier stages 3. At the same time, the current capacitor 8 begins to charge via the rectifier 9. Due to the fact that the capacity of the individual capacitors in the multiplier cascades is selected to be small (hundreds of picofarads), the total charging capacity of the capacitors of the multiplier cascade is small (tens of picofarads) compared to the capacity of the current capacitor of 0.05-0.5 µF (providing an effective duration of damaging pulse in hundreds of microseconds at a load of 1 kOhm). At the start of operation of the inverter 4, the capacitors of the multiplier cascades are charged first and when the voltage potential rises to the ignition voltage of the protective regulating spark gap 11, it ignites and the initial pre-ionization electrical breakdown of the air gap appears, regardless of the distance between the output electrodes of the ESHO or DESHO and the bio-target, between the output electrodes 10 and 12 and the bio-target, but at the same time the capacitor 8 is still being charged. With a small distance between the output electrodes and the bio-target, the pre-ionization potential of the output voltage formed by the multiplier for the breakdown between the electrodes 10 and 12 will be relatively low (but already higher than the generator supply voltage), and at a large distance between the output electrodes and the bio-target, the output voltage potential of the multiplier will be close to the full potential of the breakdown of the maximum distance of the combat discharge gap between the output electrodes. Into the electrospark ionized channel created by the multiplier 3, the resistance of which channel is small practically regardless of its length (i.e., in fact, of the distance between the output electrodes and the bio-target), the current capacitor 8 is discharged via the current spark gap 7 and the high-voltage diode assembly 6, but only at the moment when its charge voltage reaches the total potential of the voltage drop during operation of the multiplier at a given breakdown distance between the output electrodes and the bio-target, since the spark gap 7 does not ignite with an incomplete charge voltage in the capacitor 8. The spark gap 7 is a threshold unit responsible for the full charge of the capacitor 8 which, due to the significant capacity, provides necessary duration of physiologically effective pulse (80-120 µs). Therefore, the frequency of the generator operation is practically irrespective of the distance between the electrodes 10 and 12 or between the electrodes and the bio-target. The presence of the preliminary breakdown of the distance between the electrodes 10 and 12 before the discharge of the current capacitor into the ionized channel can be seen in the slow motion filming of the generator operation, and the presence of a characteristic whistling sound (the formation of the thinnest leaders of preliminary electrical breakdown from the operation of the multiplier) preceding the main discharge of the current capacitor at small distances between the electrodes 10 and 12 and a large capacity (0.06-0.1 microfarad) of the current capacitor 8. The same characteristic whistling sound also characterizes the operation of the generator of FIG. 2, see below. Due to the fact that the capacity of the capacitors of the multiplier cascades is only tens of picofarads (to prevent large energy consumption for the pre-ionization discharge from the power source), the voltage drop at different potentials at the output electrodes does not differ much, provided that the output power of the generator supply inverter 4 is significantly exceeded over the power consumed by the multiplier at different breakdown distances between the output electrodes and the bio-target. In this case, the charge voltage across the current capacitor 8 will be almost constant and close to the output voltage of the inverter 4, corrected for the voltage drop across the multiplier before the electrical breakdown of the air gap at different distances between the output electrodes and the bio-target. The high-voltage diode assembly 6 is connected in reverse polarity to the polarity of the working potential of the multiplier 3, and therefore the cascades of the capacitor stages of the generator multiplier cannot be discharged via the current spark gap 7 and the current capacitor 8. The capacitor 8 must have a permissible operating voltage equal to or slightly higher than the maximum output voltage of the inverter 4. When discharging the large-capacity capacitor 8 into a load via the discharge channel ionized by the multiplier 3, a long discharge pulse is achieved at a peak amplitude at the load close to the charge voltage in capacitor 8. In rare cases arising from using the generator in the ESHO or DESHO (for example, the direct inserting of pointed output electrodes of the ESHO into the body, without a layer of clothes, or inserting the needles of the current conducting wires fired by the DESHO into the body of the bio-target), the output electrodes will be loaded with insignificant electrical resistance (as accepted by GOST (USSR State standard specification) R 50940-96 and other regulatory documents, the resistance of the human body without clothes is 1 kOhm). In this case, the charge current of the generator supply voltage with a large voltage drop will pass to the output electrodes without charging the capacitors of the multiplier stages and the current capacitor 8. In such a rare case (since direct contact of the electrodes with the epidermis of the bio-target without clothes is quite rare) of use of the ESHO and DESHO, operation of the generator in the pulse mode with the discharge of the current capacitor 8 to the bio-target becomes impossible. To prevent the passage of the generator supply voltage current to the output electrodes at low resistances between them (that is, in direct contact of the output electrodes with the epidermis of the bio-target), a protective regulating spark gap 11 is used, which is arranged directly between the point 5 in the circuit and the output electrode 12. The protective regulating spark gap 11 has ignition voltage exceeding the value of the maximum output voltage of the inverter 4. Therefore, even with direct contact of the output electrodes with the bio-target, the protective regulating spark gap 11 will not ignite before the capacitor 8 is fully charged and the potential in the cascades of the multiplier 3 will increase more than the ignition voltage of the spark gap 11. Protective and regulating spark gap 11 performs not only the function of preventing the generator from stopping operation when the output electrodes 10 and 12 are in direct contact with the epidermis of the bio-target, but also the function of regulating the maximum breakdown distance in air between the output electrodes 10 and 12. At the ignition voltage of the protective regulating spark gap 11, only by a few percent exceeding the maximum supply voltage (as, for example, in the generator described as the second analogue), due to the small capacity of the cascade capacitors and the insignificant output power (less than 0.5-1 W) of the multiplier itself, the potential at the output electrodes of the multiplier builds up relatively slowly, while the electrodes of the discharge gap begin to exhibit a corona dissipating potential and, as a result of which, due to the lack of output power of the multiplier, the capacitors of the cascade are undercharged to the full possible peak voltage to form the pre-ionization discharge of the maximum length. Increasing the output power of the multiplier itself is absolutely inappropriate, since the task of the multiplier is not to produce a physiologically effective discharge, but only to create an ionized gap between the ESHO or DESHO and the target for the discharging of the current capacitor into that ionized gap. Therefore, the intrinsic output power of the multiplier is selected to be the smallest possible, only for the spark pre-ionization breakdown of the structurally required distance between the output electrodes of the ESHO or DESHO. To obtain the full maximum length necessary for the pre-ionization discharge, that is, to increase the charge potential of the capacitors of the multiplier cascades, the ignition voltage of the protective regulating spark gap 11 is selected significantly higher (by 50-200%) than the value of the maximum output voltage of the inverter 4. Specific ignition voltage of the protective regulating spark gap 11 is selected depending on the required maximum designed distance between the output electrodes of the ESHO or DESHO. The protective regulating spark gap, depending on the design of the ESHO or DESHO (the presence of the necessary space for placement), can be installed between the point 5 and the output electrode 12 or in front of the output electrode 10, or in the two abovesaid places, but in this case, the selection of the required ignition voltage becomes more complicated since the ignition voltage of the two gas spark gaps is not equal to the sum of the individual voltages of each spark gap. Correct selection of the ignition voltage of the protective regulating gas spark gap 11 allows to increase the maximum distance of the spark breakdown between the output electrodes of the generator by 25-30% compared to the distance of the spark breakdown of the voltage multiplier used in the generator. A closed (sealed) air spark gap provides a smaller addition of the spark breakdown distance between the output electrodes of the generator.

The efficiency factor of the inventive generator exceeds the efficiency factor of the generator described as the second analogue due to the fact that there are no ohmic losses in the voltage multiplier and no current flow across the protective dividing resistors of the Marx generator. In addition, the inventive generator has no corona discharge losses in the spark gaps of the Marx generator. High voltage microgenerators for use in ESHO and DESHO of any type are necessarily filled with polymer compounds having high electric strength, but in the case of Marx generator use, the spark gaps should be located in the air outside the capacitors and resistors filled with the compound, thereby providing power losses in corona discharge. The capacitors and diodes of the cascade multiplier are filled completely with the compound, without corona parts having access to the pouring surface except for the output electrodes, but the development of a corona discharge at the output electrodes of the proposed generator is limited by using the protective regulating spark gap 11.

The overall dimensions of the proposed generator with the same spark electrical breakdown distances in air as the generator described as the second analogue and much shorter pulse duration due to the fact that there are no air spark gaps in the cascades and the free space around the spark gaps in the cascades required when built them into the ESHO or DESHO body to prevent the formation of sliding discharges bypassing the spark gaps, according to the design.

The ignition of the current spark gap 7 results not only from the maximum charge voltage of the current capacitor 8, but also from the throughput properties of the intrinsic capacity of the high-voltage diode assembly 6, which, in the event of the breakdown of the air gap between the electrodes 10 and 12 and the bio-target and also the air or gas gap of the protective regulating spark gap 11 or only the spark gap 11 (in the case of direct contact of the electrodes 10 and 12 with the epidermis of the bio-target) passes the potential of the discharge pulse of the cascade multiplier 3 to the current spark gap 7, creating an additional ignition potential than the potential of the full charge voltage in the current capacitor 8. If it is necessary to obtain a high pulse frequency but with the capacitor 8 is undercharged to the full possible energy, the ignition voltage of the current spark gap 7 is selected equal to the value of the maximum output voltage of the inverter 4, and if it is necessary to obtain a lower pulse frequency but with the full possible charge voltage in the capacitor 8, the ignition voltage of the current spark gap 7 is selected higher than the values of the maximum output voltage of the inverter 4 and up to 200% more than the maximum output voltage of the inverter. The ignition voltage of the current spark gap 7 is selected based on both the required frequency of the pulses produced and the energy in the pulse and depending on the capacitive properties of the high-voltage diode assembly 6, the capacity of which depends on the type of high-voltage diodes used and a number of diodes in the high-voltage assembly. The number of diodes in the assembly depends on the required reverse voltage in the assembly, depending on the selected distance of the electrical spark breakdown in air between the electrodes 10 and 12. Also, one of the conditions for stable operation of the generator is that the capacity of the current capacitor 8 significantly exceeds the total full charging capacity of the cascades of the multiplier stages, but such a condition, in any case, must be met in the ESHO and DESHO in order to produce pulses of a physiologically effective duration. The pulse frequency and pulse energy generated by the generator at a constant value of the capacity of the current capacitor 8 (and, accordingly, a constant pulse duration) can be controlled to some extent by the ignition voltage of the current spark gap 7, which can have an ignition voltage that is higher or equal to the value of the maximum output voltage of the inverter 4. At the lowest frequency, the energy accumulated in the capacitor 8 will be the highest (full charge), and at the highest frequency, the energy will be the lowest. However, the maximum physiological effectiveness is achieved with the optimal ratio of frequency and amplitude, assuming equal duration on the load (that is, the output power of the ESHO or DESHO), and is set based on the permissible medical standards in the country of application (usually different standards for civilian and police versions of the ESHO and DESHO). To power the generator, it is most advisable to use an inverter with a push-pull (double-step) cascade, a push-pull with a master oscillator or an autogenerator push-pull (for example, on a multivibrator).

The topology of the rectifier 9 shown in FIG. 1, which rectifier comprises two diodes and a pass capacitor 13, is optimal for the operation of a self-oscillating multivibrator with a step-up transformer having an output voltage of 1-5 kV, which is widely used in domestic ESHO of leading Russian companies producing non-lethal weapons, as a DC/AC inverter [8] for a Cockcroft-Walton (Greinacher) cascade voltage multiplier. With other types of inverters and multiplier topologies, it is possible to use rectifiers in the form of a diode bridge and other designs of one half period or full-wave rectifiers. As a high-voltage diode assembly 6, it is necessary to use a series circuit of high-voltage diodes or single housing high-voltage diode assemblies with the highest possible values of the permissible forward pulse current, reverse voltage, and the minimum reverse current.

The proposed generator can also be used when there is a need for electrical breakdown of large gas, air or liquid gaps, followed by the creation of a high energy plasma-arc discharge of considerable duration, for example, in electrohydraulic plants, electrothermal artillery pieces, to excite shock waves in condensed media; generation of intense flashes of light radiation during discharges in gases, generation and acceleration of high power pulsed electron and ion beams, creation of pulsed gas lasers, etc. The high-voltage potential developed by the cascade multiplier makes it possible to obtain the distances of the high-current electrical spark breakdown in centimeters and tens of centimeters with small sized configurations of the generator and in hundreds of centimeters with large sized configurations. In the cascade multiplier, small sized ceramic capacitors with a small capacity (tens to hundreds of picofarads) with permissible charge voltage of 3-6 kV and high-voltage diodes with permissible direct current of no more than 5 mA (for example, series 2CL70 ÷ 2CL74) can be used, which allows the generator to be made with the dimensions required for use in the ESHO and DESHO.

When configuring a generator of the proposed type, any type of voltage multiplier can be used, however, the use of Cockcroft-Walton (Greinacher) cascade generator seems to be the most optimal due to the most convenient layout of printed circuit boards for a generator of the given topology according to the criterion of maximum density of elements placement with sufficient electric strength of the thicknesses of the sealing compound for generator boards. This topology provides both the minimum possible margin for the breakdown voltage of the selected diodes and capacitors (2U), and also the possibility of use of the minimum output voltages of the inverter, which are optimal for the conditions of sufficient electric strength of domestic small-sized output transformers of inverters.

Said properties of the proposed generator make it particularly promising for use in the ESHO and DESHO with long output pulses, that is, with high physiological effectiveness, providing an immobilizing effect on the bio-target without the use of the high-voltage pulse output transformers.

FIG. 2. A shock current generator with a topology designed for the use of a power source with an increased output voltage operates as follows: At outputs 14 and 15 designated for charging the stages of a four-stage voltage multiplier 16 (highlighted by a dashed line in FIG. 2), an alternating voltage of a power source of 5-10 kV, received from an inverter 17, which is a DC/AC-converter (of constant low (3-12 V) voltage of the power supply, that is a battery or accumulator, into high alternating or pulsed voltage of 5-10 kV), is supplied. To the point 18 in the circuit (one output of the multiplier 16), a high-voltage diode assembly 19 is connected in reverse polarity to the output potential of the multiplier and an air or gas current spark gap 20 is connected in series with the diode assembly 19, and then one output of the current capacitor 21 charged via the bridge rectifier 22 of the electrical current received from the inverter 17, and to the second output of the capacitor 21, a high-voltage diode assembly 23 is connected unipolarly with the diode assembly 19, which diode assembly 23 is connected to the output 24 of the multiplier 16 and one output electrode 25 of the generator. Such an arrangement of diode assemblies, as the built experimental generators have proven, reduces the possibility of an unacceptable overvoltage on the current capacitor 20 when the generator is supplied with an increased voltage of the inverter 17. To the point 26 in the circuit, one output of the protective regulating air or gas spark gap 27 is connected, the second output of which is the second output electrode 28 of the generator. A resistor 30 is arranged between the output of the inverter 29 and the output 15 of the multiplier 16.

The generator works as follows. When the inverter 17 is turned on, the alternating current of the generator supply generated by the inverter enters the multiplier and charges the capacitors of the cascade of the multiplier stages 16. At the same time, the current capacitor 21 begins to charge via the rectifier 22. Further, the principle of operation and adjustments of this topology does not differ from the operation described in FIG. 1 except that when the multiplier 16 is powered by the increased voltage of the inverter 17 (5-10 kV) with a small number of multiplication stages, the minimum and maximum distance of the spark electrical breakdown in air between the output electrodes at a stable frequency of the output pulses is regulated by the resistor 30 rather than by the protective regulating spark gap 27 (compared to the topology of FIG. 1), while at a decrease in resistance of the resistor 30 (the smallest is 0 Ohm), the greatest distance of the electrical spark breakdown in air between the output electrodes is achieved, at a less stable frequency of the generator operation in the case of a small distance between the output electrodes, and at an increase in the resistance of the resistor 30 (tens and hundreds of kOhm), the distance of the spark electrical breakdown in air between the output electrodes decreases, but the frequency of the output pulses remains stable at any of the possible distances between the output electrodes (as in the generator of FIG. 1). This topology is optimal when purchased small sized inverters made in China [9] are used in DESHO, which inverters differ from the inverters having a high output voltage combined with a large margin of electric strength and low cost, which are used in the domestic manufacturing of ESHO and DESHO. The use of resistor 30 in the circuit according to FIG. 1 is less expedient since the regulating capacities of the resistor in the generator with the cascade multiplier having a large number of multiplication stages are significantly reduced in comparison with the multiplier according to the topology shown in FIG. 2. which is widely used in circuits of the ESHO with voltage multipliers.

### Example of the implementation

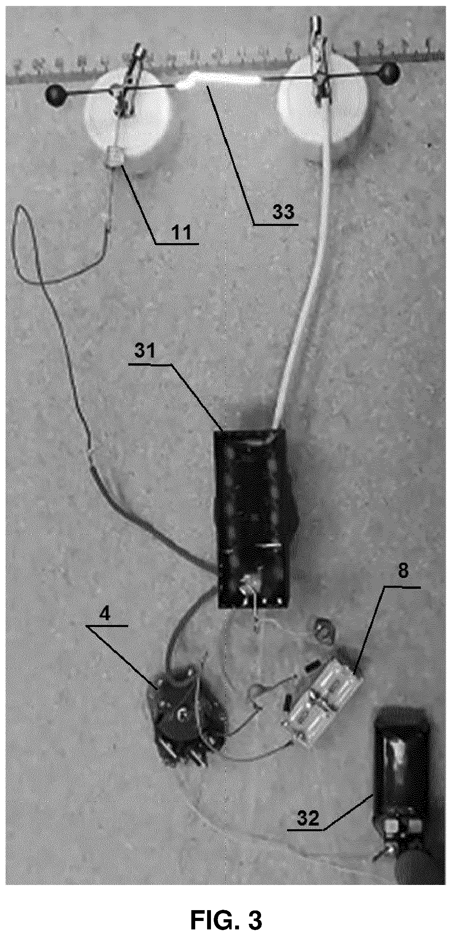

FIG. 3. Experimental 12-stage cascade generator according to the topology of FIG. 1. (Cockcroft-Walton (Greinacher)). A unit 31 comprising a multiplier, high-voltage diode assembly and spark gap filled with transparent high-voltage compound, a battery 32 for power supply to the inverter 4, a current capacitor 8, a protective regulating spark gap 11, and an electrical spark discharge 33.

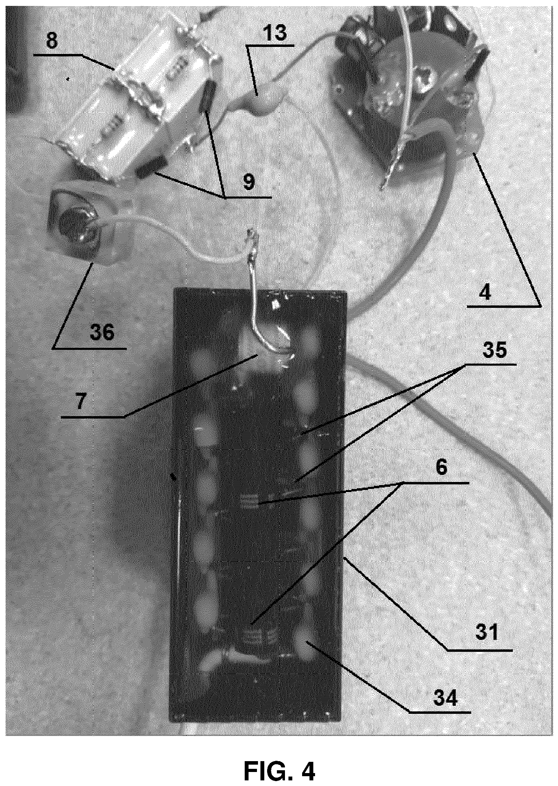

FIG. 4. A housing of the unit 31, an inverter 4, a high-voltage diode assembly 6, a current gas spark gap 7, a current capacitor 8, a rectifier 9, a pass capacitor 13, capacitors 34 of the multiplier stages, diodes 35 of the multiplier stages, an additional adjustable spark gap 36 designed to change the generator frequency during experiments. In the cascades of the generator multiplier, ceramic capacitors (470 pF; 5 kV) from Murata company, diodes 2CL70 (from XUYANG Electronics company), current capacitor (series-parallel assembly of 4 film capacitors (47 nF; 1600 V)) (total 0.047 µF x 3200V) from Rifa company, 4500 V gas current gap, a sealed adjustable air spark gap from ZAO "Oberon-Alpha", 2500 V protective regulating gas spark gap from Epcos company, high-voltage diode assemblies CL01-12 (12 kV; maximum permissible direct impulse current 50 A) from Rugao Dachang Electronics Co., Ltd., and inverter from OOO "MART-GROUP» company are used. The generator has an output pulse frequency of 150-170 Hz, an amplitude of 3.5-3.8 kV at a load of 1000 Ohm, and a pulse duration of 85-90 µs.

### List of sources cited:

1. Cascade generators. http://hea.phys.msu.ru/Boss/user-files/kaskadnye_generatory.pdf
2. https://en.wikipedia.org/wiki/Cockcroft-Walton_generator
3. Ladyagin Yu.O. "Remote-acting electroshock weapons" Moscow: Stalingrad Foundation Publishing House, 2017, p. 447.
4. Ladyagin Yu.O. "Remote-acting electroshock weapons" Moscow: Stalingrad Foundation Publishing House, 2017, p. 350 and additionally pp. 374-386.
5. Ladyagin Yu.O. "Remote-acting electroshock weapons" Moscow: Stalingrad Foundation Publishing House, 2017, pp. 446-447.
6. Marx pulse voltage generators (GIN). http://hea.phys.msu.ru/Boss/user-files/generatory_impulsnogo_napryazheniya.pdf
7. Ladyagin Yu.O. "Remote-acting electroshock weapons" Moscow: Stalingrad Foundation Publishing House, 2017, pp. 448-450.
8. Ladyagin Yu.O. "Remote-acting electroshock weapons" Moscow: Stalingrad Foundation Publishing House, 2017, p. 467 (fig. 289).
9. https://ru.aliexpress.com/item/3-6-1-5A/32969616607.html?spm=a2g0v.10010108.1000014.1.367f764bu6NBHZ&pvid=58 ea5b50-6ad7-44a2-bf60-0bdeb13850fd&gps-id=pcDetailBottomMoreOtherSeller&scm=1007.13338.112281.000000000000000&sc m-url=1007.13338.112281.000000000000000&scm_id=1007.13338.112281.0000000000 00000

## Claims

1. A shock current generator for electroshock weapons comprising a voltage multiplier with output electrodes and stages charged by the voltage of a power source of 1 ... 10 kV, wherein a current capacitor charged via a solid-state rectifier with the input voltage of the power source supplying the cascades of the voltage multiplier stages is connected parallel to the output electrodes of the voltage multiplier via at least one solid-state high-voltage diode assembly, which is connected in reverse polarity to the polarity of the output potential of the voltage multiplier, and an air or gas spark gap, and at least one preferably protective regulating gas spark gap is arranged in the electrical circuit between at least one output electrode of the generator and the remaining elements of the electrical circuit of the generator.

2. The generator according to claim 1, wherein a resistor is arranged in the electrical circuit between the input terminal of the power supply of the voltage multiplier and the output terminal of the power supply.
